**Europäisches Patentamt**

(19) **European Patent Office**

**Office européen des brevets**

(11) Veröffentlichungsnummer: **0 274 622 B1**

(12) **EUROPÄISCHE PATENTSCHRIFT**

(45) Veröffentlichungstag der Patentschrift:
**07.11.90**

(21) Anmeldenummer: **87117231.8**

(22) Anmeldetag: **23.11.87**

(51) Int. Cl.⁵: **H01J 37/10,** H01J 37/244,
H01J 37/28

(54) **Detektoranordnung mit einem Detektorobjektiv für Korpuskularstrahlgeräte.**

(30) Priorität: **12.12.86 DE 3642559**

(43) Veröffentlichungstag der Anmeldung:
**20.07.88 Patentblatt 88/29**

(45) Bekanntmachung des Hinweises auf die Patenterteilung:
**07.11.90 Patentblatt 90/45**

(84) Benannte Vertragsstaaten:
**DE FR GB IT NL**

(56) Entgegenhaltungen:
**EP-A- 0 138 610
EP-A- 0 242 602
DE-A- 3 236 271
GB-A- 2 081 501**

**PATENT ABSTRACTS OF JAPAN, unexamined
applications, Sektion E, Band 9, Nr. 244, 30.
September 1985, THE PATENT OFFICE JAPANESE
GOVERNMENT, Seite 96 E 346**

(73) Patentinhaber: **ICT Integrated Circuit Testing
Gesellschaft für Haibleiterprüftechnik mbH,
Klausnerring 1a, D-8011 Heimstetten(DE)**

(72) Erfinder: **Feuerbaum, Hans-Peter, Dr. Ing.,
Arno-Assmann-Strasse 14, D-8000 München 83(DE)**
Erfinder: **Frosien, Jürgen, Dr. Ing., An der Ottosäule 18,
D-8012 Ottobrunn(DE)**

(74) Vertreter: **Tetzner, Volkmar, Dr.-Ing. Dr. jur.,
Van-Gogh-Strasse 3, D-8000 München 71(DE)**

# Beschreibung

Die Erfindung betrifft eine Detektoranordnung mit einem Detektorobjektiv für Korpuskularstrahlgeräte.

Die elektrischen Eigenschaften moderner hochintergrierter mikro- und optoelektronischer Bauelemente werden wesentlich von den geometrischen Strukturabmessungen ihrer Bausteinkomponenten beeinflußt. Die Einhaltung enger Maßtoleranzen ist deshalb insbesondere dann eine unverziohtbare Voraussetzung für die Herstellung funktionsfähiger Bauelemente mit gleichbleibenden physikalischelektrischen Eigenschaften, wenn sich die geometrischen Abmessungen der Feinstrukturen (z.B. Leiterbahnen, Finger eines Wandlers) bei Anwendung moderner lithografischer Verfahren im Mikrometer- und Submikrometerbereich bewegen.

In allen Bereichen der Entwicklung und Fertigung hochintergrierter mikro- und optoelektronischer Bauelemente besteht deshalb ein steigender Bedarf an hochauflösenden abbildenden Systemen, die eine prozeßnahe Inspektion und Vermessung der erzeugten Strukturen ermöglichen. Als für diese Zwecke besonders geeignet haben sich Rasterelektronenmikgroskope herausgestellt, mit denen man Mikro- und Submikrometerstrukturen visuell beurteilen, Fehler und Abweichungen von Sollmustern feststellen und topographische Daten wie Längen, Breiten, Höhen oder Neigungswinkel, erfassen und auswerten kann. Bei allen Untersuchungen der Bauelemente im Rasterelektronenmikroskop ist hierbei sicherzustellen, daß Veränderungen am Substrat, wie sie beispielsweise durch Kontaminationen oder Strahlenschäden auftreten können, vermieden werden.

Konventionelle Rasterelektronenmikroskope erreichen die heute geforderte Auflösung von wenigen Nanometern nur bei hohen Beschleunigungsspannungen oberhalb etwa 20 kV, wo Restiststrukturen und Schaltungen durch die hochenergetischen Elektronen geschädigt und nicht- oder schlechtleitende Oberflächenbereiche der untersuchten Probe aufgeladen werden. Das in der Rasterelektronenmikroskopie übliche Metallisieren der Probe zur Vermeidung der die Auflösung und die Abbildungsgüte beeinträchtigenden Aufladungen ist für die Untersuchung mikro- und optoelektponischer Bauelemente nicht geeignet, da die aufgebrachte Metallschicht das Bauelement in seiner Funktion stören und es für die weitere prozeßtechnische Behandlung in nicht tolerierbarer Weise verändern würde.

Gegenstand der prioritätsälteren, nicht vorveröffentlichten EP-A 0 242 602 ist eine elektrostatisch-magnetische Linse für Korpuskularstrahlgeräte, die eine ein nahezu rotationssymmetrisches magnetisches Feld erzeugende Magnetlinse und eine ein nahezu rotationssymmetrisches elektrisches Feld erzeugende elektrostatische Immersionslinse enthält, die mindestens zwei auf unterschiedlichem Potential liegende Elektroden aufweist und innerhalb der Magnetlinse symmetrisch zu deren Symmetrieachse angeordnet ist.

Durch "Patent Abstracts of Japan", Bd. 9, Nr. 244 (E-346), 1967, JP-A 6 095 843 ist weiterhin eine Elektronenstrahlanordnung bekannt, bei der oberhalb einer Objektivlinse ein Sekundärelektronendetektor angeordnet ist. Weiterhin ist eine auf negativem Potential liegende Elektrode vorgesehen, die einen Teil der Sekundärelektronen abweist und nicht zum Detektor gelangen läßt.

Der Erfindung liegt die Aufgabe zugrunde, eine Detektoranordnung anzugeben, mit der die Auflösung und die Detektoreffizienz eines Korpuskularstrahlgerätes, insbesondere eines Rasterelektronenmikroskopes, bei niedrigen Beschleunigungsspannungen deutlich gesteigert werden kann. Diese Aufgabe wird erfindungsgemäß durch eine Detektoranordnung nach Patentanspruch 1 gelöst.

Der mit der Erfindung erzielbare Vorteil besteht insbesondere darin, daß Korpuskularsonden mit kleinem Strahlquerschnitt auch bei hohen Strahlströmen und niedrigen Beschleunigungsspannungen erzeugt werden können. Außerdem ist eine hochauflösende und nahezu aufladungsneutrale Untersuchung nicht- oder schlechtleitender Proben gewährleistet.

Die Ansprüche 2 bis 20 sind auf bevorzugte Ausgestaltungen und Weiterbildungen der Erfindung gerichtet. Die Erfindung wird nachfolgend anhand der Zeichnungen näher erläutert.

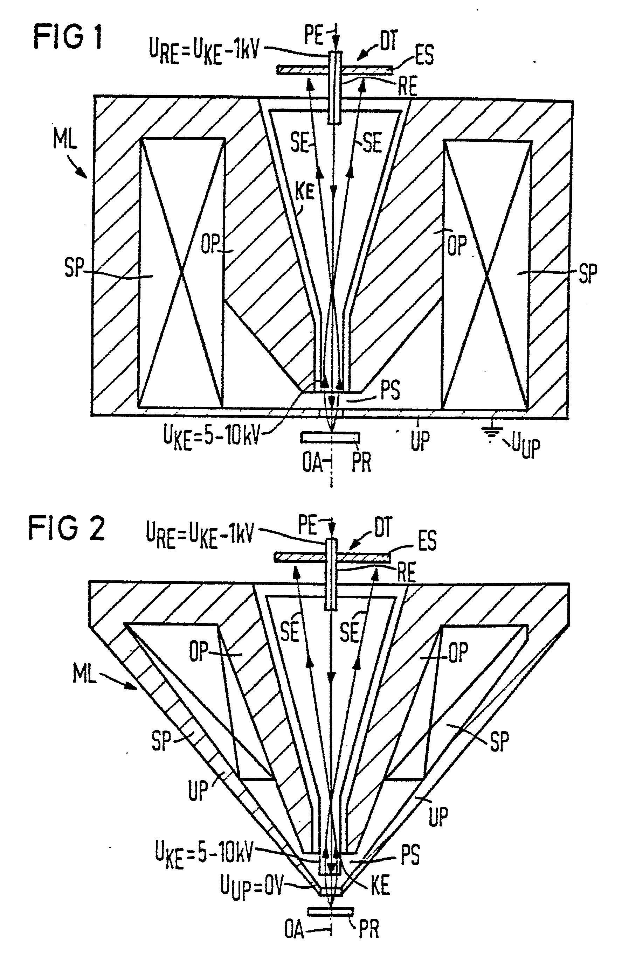

Hierbei zeigen die Fig. 1 und 2 Ausführungsbeispiele erfindungsgemäßer Detektoranordnungen für ein Rasterelektronenmikroskop.

Die in Fig. 1 schematisch dargestellte Detektoranordnung bildet die Komponente der elektronenoptischen Säule eines Rasterelektronenmikroskopes, mit der die von einer Hochstromquelle erzeugten Primärelektronen PE auf die Probe PR, vorzugsweise ein mikro- oder optoelektronisches Bauelement, fokussiert werden. Die Anordnung besteht im wesentlichen aus einer unsymmetrischen Magnetlinse ML, einer ein nahezu rotationssymmetrisches elektrisches Feld erzeugenden elektrostatischen Immersionslinse KE, UP und einem oberhalb des Polschuhspaltes PH, insbesondere unmittelbar oberhalb des Linsenkörpers angeordneten Detektor DT zum Nachweis der auf der Probe PR von den Primärelektronen PE ausgelösten Sekundärelektronen SE. Um möglichst geringe Brennweiten und damit kleine Farbfehlerkonstanten $C_F$ ($C_F \sim f, f$ = Brennweite des abbildenden Systems) der Objektivlinse zu gewährleisten, wird der von der Erregerspule SP erzeugte magnetische Fluß mit Hilfe des oberen und unteren Polschuhes OP bzw. UP auf einen kleinen Raumbereich um die Symmetrieachse OA des Systems konzentriert, wobei das um diese Achse nahezu rotationssymmetrische Magnetfeld im Polschuhspalt PS seine maximale Stärke erreicht. Eine Elektrode KE der elektrostatischen Immersionslinse, die in dem gezeigten Ausführungsbeispiel vorzugsweise in Form eines sich in Richtung der Probe PR verjüngenden Kegelstumpfes mit einem im Bereich des Polschuhspalts PS zylinderförmigen Ansatz ausgebildet ist, wird in der ebenfalls kegelstumpfförmigen Bohrung des oberen Polschuhes OP der Magnetlinse ML konzentrisch zu deren Symmetrieachse OA isoliert angeordnet. Der untere Polschuh UP der Magnetlinse ML, der vorzugsweise auf Erdpotential $U_{UP}$ liegt und zum Schutz gegen Kontamination mit einem in Fig. 1 nicht dargestellten Strahlführungsrohr aus magnetischem oder unmagnetischem Material ausgekleidet sein kann, bildet hierbei die untere Elektrode der elektrostatischen Immersionslinse. Um innerhalb des Detektorobjektivs ein nahezu rotationssymmetrisches elektrisches Verzögerungsfeld aufzubauen, legt man die obere Elektrode KE der Immersionslinse bezüglich des unteren Polschuhes UP auf ein positives Potential $U_{KE}$ von beispielsweise 5 bis 10 kV.

Die Abbildungseigenschaften dieser aus elektrostatischer Immersionslinse und magnetischer Linse ML bestehenden elektronenoptischen Einheit werden im wesentlichen von den Elektrodenpotentialen $U_{KE}$ bzw. $U_{UP}$, den Abmessungen der Elektroden und der Magnetfeldstärke im Polschuhspalt PS bestimmt. So ist es keineswegs erforderlich, die obere Elektrode KE kegelstumpfförmig auszubilden. Es kann auch eine hohlzylinderförmige Elektrode verwendet werden, die im Unterschied zu der in Fig. 1 dargestellten Detektoranordnung in einer ebenfalls zylinderförmigen Bohrung des oberen Polschuhes OP angeordnet ist.

Aufgrund des dem fokussierenden Magnetfeld überlagerten elektrischen Verzögerungsfeldes der Immersionslinse zeigt die erfindungsgemäße Detektoranordnung deutlich geringere Aberrationen (Farb- und Öffnungsfehler) als die magnetische Linse ML bei konventionellem Betrieb ($U_{KE}$ = O). So werden die im wesentlichen von der zwischen den Elektroden der Immersionslinse (kegelstumpfförmige Elektrode KE und unterer Polschuh UP) aufgebauten Potentialdifferenz $U_{KE} - U_{UP}$ bestimmten Farb- und Öffnungsfehlerkonstanten des zusammengesetzten Systems verglichen mit denen der magnetischen Einzellinse um etwa einen Faktor 10 reduziert, wenn man die Elektronen im Detektorobjektiv auf $1/10$ ihrer Primärenergie (kinetische Energie der Elektronen im Strahlengang unmittelbar oberhalb des Detektorobjektivs) abbremst. Die erfindungsgemäße Detektoranordnung besitzt außerdem den Vorteil, daß sich ihre elektronenoptische Eigenschaften wegen der ausgezeichneten und einfachen Zentrierbarkeit der elektrischen und der magnetischen Linse sehr gut in der Praxis realisieren lassen.

Der Detektor DT zum Nachweis der an einem nicht näher bezeichneten Meßpunkt auf der Probe PR von den Primärelektronen PE ausgelösten Sekundärelektronen SE ist in dem gezeigten Ausführungsbeispiel unmittelbar oberhalb des Linsenkörpers symmetrisch zur Symmetrieachse OA angeordnet. Er besteht vorzugsweise aus einem ringförmigen elektronensensitiven Teil ES und einem in dessen Zentralbohrung isoliert eingepaßten Hohlzylinder RE zur Abschirmung des Strahles der Primärelektronen PE von der am Detektor DT anliegenden Hochspannung von beispielsweise + 10 kV. Dieser Hohlzylinder RE, der zur Ablenkung der unter kleinen Winkeln relativ zur Symmetrieachse OA laufenden Sekundärelektronen SE mit einem etwas niedrigeren positiven Potential $U_{RE}$ ($U_{KE} - $ lkV $\leq$

$U_{RE} \leq U_{KE}$) als die obere Elektrode KE der Immersionslinse beaufschlagt seinkann, reicht bis in das Innere des Linsenkörpers hinein. Als Detektoren kommen insbesondere die beispielsweise aus der Veröffentlichung von W.K. Hofker, Philips Technische Rundschau Nr: 12, 1966, Seite 323 bis 337 bekannten Halbleiterdetektoren in Betracht, deren teilchensensitiven Bereiche ES ggf. segmentiert aufgebaut und als Metall-Halbleiter- oder p–n–Übergang ausgebildet sind. Selbstverständlich kann man auch Szintillator-Lichtleiterkombination oder Channel-Plates verwenden. Ringförmige Sekundärelektronendetektoren, die im Unterschied zu Fig. 1 auch innerhalb des Linsenkörpers angeordnet sein können, besitzen gegenüber anderen Detektorkonfigurationen den Vorteil, daß sie nahezu alle durch das positive Potential $U_{KE}$ der oberen Elektrode KE von der von der Probe PR abgesaugten und im Feld der Magnetlinse ML fokussierten Sekundärelektronen SE erfassen. Um Wandberührungen der Sekundärelektronen SE zu vermeiden, ist darauf zu achten, daß die Abmessungen der kegel- oder zylinderförmigen Bohrung im oberen Polschuh OP größer als der maximale Durchmesser des innerhalb des Detektorobjektivs erzeugten divergierenden Sekundärelektronenbündels sind.

Eine Detektoranordnung mit konischer Magnetlinse ML ist schematisch in Fig. 2 dargestellt, in der gleiche Bezugszeichen die gleichen Anordnungselemente wie in Fig. 1 bezeichnen. Konische Objektivlinsen werden in Rasterelektornenmikroskopen vorzugsweise dann eingesetzt, wenn großflächige Proben auch in gekipptem Zustand bei kleinem Arbeitsabstand (Abstand zwischen der Probe und der unteren Polschuhplatte) abgebildet und untersucht werden sollen. Aufgrund ihrer Polschuhform besitzen konische Magnetlinsen allerdings eien großen Polschuhspalt PS und damit eine vergleichsweise große Brennweite, was wiederum relativ große Farb- und Öffnungsfehler bedingt. Durch die Anordnung einer auf positivem Potential $U_{KE}$ ($U_{KE} \approx +$ 5 bis + 10 kV) liegenden zylinder- oder, wie in Fig. 2 dargestellt, kegelstumpfförmigen Elektrode KE im oberen Polschuh OP werden die Abbildungseigenschaften der aus konischer Magnetlinse ML und elektrostatischer Immersionslinse bestehenden elektronen-optischen Einheit, verglichen mit der konischen Einzellinse ($U_{KE}$ = 0 Volt), deutlich verbessert. Diese Verbesserung der optischen Eigenschaften erreicht man durch die eingangs beschriebene Verringerung der Farb- und Öffnungsfehlerkonstanten und eine Verschiebung der Hauptebene der konischen Magnetlinse ML in Richtung der Probe PR, was sich auf Grund der damit einhergehenden Verkürzung der Brennweite wiederum günstig auf die Aberrationen auswirkt (Farbfehlerkonstante CF ~ Brennweite). Auch in diesem Ausführungsbeispiel bildet der vorzugsweise auf Erdpotential $U_{UP}$ liegende untere Polschuh UP der Magnetlinse ML eine Elektrode der elektrostatischen Immersionslinse.

Die dem Strahldurchmesser d auf der Probe proportionale Auflösung eines Rasterelektronenmikroskopes wird bei niedrigen Beschleunigungsspannungen im wesentlichen von der der Fokussierung entgegenwirkenden Coulomb-Abstoßung der Elektronen (Boersch-Effekt) und dem axialen Farbfehler der abbildenden Linse bestimmt, der nach der Gleichung 2) mit der Farbfehlerkosntanten $C_F$ und bei gleichbleibender Breite $e \Delta U$ der Energieverteilung derElektronen mit abnehmender Primärenergie $eU$ anwächst. Für den die Auflösung bestimmenden Sondendurchmesser d auf der Probe gilt hierbei die bekannte Beziehung

$$d = (d^2_O + d^2_F)^{1/2} \quad 1.)$$

wobei dO den um die Coulomb-Abstoßung der Elektronen zwischen Strahlerzeuger und Probe (lateraler Boersch-Effekt) erweiterten geometrisch-optischen Sondendurchmesser und dF den Durchmesser des durch den Farbfehler erzeugten Farbfehlerscheibchens bezeichnet, der über die Beziehung

$$d_F = C_F \cdot \alpha \cdot \Delta U/U \quad 2.)$$

von der Strahlapertur $\alpha$, der Farbfehlerkonstanten $C_F$ der Linse, der Primärenergie $eU$ ($U$ = Beschleunigungsspannung) und der Breite der Energieverteilung $e \Delta U$ der Elektronen abhängt. Eine Verbesserung der Auflösung eines Rasterelektronenmikroskopes kann daher nur durch eine Reduktion der nachteiligen Einflüsse der Elektron-Elektron-Wechselwirkung (Reduktion des die Energiebreite $e \Delta U$ beeinflussenden energetischen Boersch-Effektes und des den Sondendurchmesser beeinflussenden lateralen-Boersch-Effektes) und der Farbfehlerkonstanten $C_F$ der verwendeten Linsen erreicht werden.

Die erfindungsgemäßen Detektoranordnungen werden deshalb vorteilhafterweise in Rasterkorpuskularmikroskopen, vorzugsweise Rasterelektronenmikroskopen eingesetzt, in denen der Boersch-Effekt die Auflösung insbesondere bei niedrigen Beschleunigungsspannungen begrenzt und konventionelle Objektivlinsen zu große Aberrationen aufweisen. Da der Einfluß des lateralen Boersch-Effektes auf den Sondendurchmesser d mit wachsender kinetischer Energie $eU$ abnimmt, die Breite der Energieverteilung $e \Delta U$ der Primärelektronen insbesondere im Strahlerzeuger infolge des energetischen Boersch-Effektes aber deutlich zunimmt, sollten die Elektronen den ersten Strahlüberkreuzungspunkt (Quellen-cross over) vorteilhafterweise mit niedriger Energie (beispielsweise 2 keV) durchlaufen, um anschließend auf hohe Energien (beispielsweise 10 keV) beschleunigt und erst kurz vor dem Erreichen der Probe auf die gewünschte niedrige Endenergie (beispielsweise 1 keV) abgebremst zu werden. Zur Abbremsung und Fokussierung der Primärelektronen verwendet man vorzugsweise eine erfindungsgemäße Detektoranordnung, die die konventionelle Objektivlinse in der elektronenoptischen Säule des Rasterelektronenmikroskopes ersetzt und deren obere Elektrode KE bei einem angenommenen Kathodenpotential von −1 kV, einer Beschleunigung der Elektronen auf 10 keV und einer gewünschten Endenergie von 1 keV auf Anodenpotential, also auf 9 kV liegt.

Die Erfindung ist selbstverständlich nicht auf die in den Fig. 1 und 2 dargestellten Ausführungsbeispiele beschränkt. So ist es beispielsweise auch möglich, symmetrische Magnetlinsen für das Detektorobjektiv zu verwenden, wobei der Detektor auch vollständig innerhalb der Linse angeordnet sein kann.

Die Elektroden der elektrostatischen Immersionslinse UP, KE können selbstverständlich auch mit anderen als den in der Beschreibung angegebenen Potentialen $U_{KE}$ bzw. $U_{UP}$ beaufschlagt werden. Hierbei ist allerdings darauf zu achten, daß eine Verbesserung der Abbildungseigenschaften des zusammengesetzten Systems nur dann Eintritt, wenn dem fokussierenden Feld der Magnetlinse ein die Primärelektronen abbremsendes elektrisches Verzögerungsfeld überlagert ist. So ist es beispielsweise auch möglich, den unteren Polschuh UP und die Probe PR gemeinsam auf ein von Null verschiedenes Potential zu legen, wenn man gleichzeitig das Potential $U_{KE}$ der oberen Elektrode KE der Immersionslinse entsprechend anpaßt.

**Patentansprüche**

1. Detektorobjektiv für Korpuskularstrahlgeräte, mit
    a) einer ein nahezu rotationssymmetrisches magnetisches Feld erzeugenden Magnetlinse (ML),
    b) einer ein nahezu rotationssymmetrisches elektrisches Feld erzeugenden elektrostatischen Immersionslinse, die innerhalb der Magnetlinse (ML) symmetrisch zu deren Symmetrieachse (OA) angeordnet ist und mindestens zwei auf unterschiedlichem Potential ($U_{KE}$, $U_P$) liegende Elektroden (KE, UP) aufweist, die ein die Korpuskeln eines primären Korpuskularstrahls (PE) abbremsendes elektrisches Verzögerungsfeld erzeugen,
    c) sowie einem zum Nachweis der von dem primären Korpuskularstrahl (PE) auf einer Probe (PR) ausgelösten Sekundärkorpuskeln (SE) dienenden Detektor (DT), der – in Richtung des primären Korpuskularstrahls geschen – vor dem Polschuhspalt (PS) der Magnetlinse (ML) symmetrisch zur Symmetrieachse (OA) angeordnet ist.

2. Detektoranordnung nach Anspruch 1, dadurch gekennzeichnet, daß eine erste Elektrode (KE) der Immersionslinse im oberen Polschuh (OP) der Magnetlinse (ML) angeordnet ist.

3. Detektoranordnung nach Anspruch 1 oder 2, dadurch gekennzeichnet, daß der untere Polschuh (UP) der Magnetlinse (ML) eine zweite Elektrode der Immersionslinse bildet.

4. Detektoranordnung nach einem der Ansprüche 1 bis 3, dadurch gekennzeichnet, daß die Magnetlinse (ML) eine sich in Richtung der Probe (PR) verjüngende kegelstumpfförmige Bohrung im oberen Polschuh (OP) aufweist.

5. Detektoranordnung nach einem der Ansprüche 1 bis 3, dadurch gekennzeichnet, daß die Magnetlinse (ML) eine zylinderförmige Bohrung im oberen Polschuh (OP) aufweist.

6. Detektoranordnung nach einem der Ansprüche 1 bis 5, dadurch gekennzeichnet, daß die erste Elektrode (KE) der Imemrsionslinse als Hohlzylinder ausgebildet ist.

7. Detektoranordnung nach einem der Ansprüche 1 bis 5, dadurch gekennzeichnet, daß die erste Elektrode (KE) der Immersionslinse als Kegelstumpf mit hohlzylinderförmigem Ansatz ausgebildet ist.

8. Detektoranordnung nach einem der Ansprüche 1 bis 7, dadurch gekennzeichnet, daß der Detektor (DT) innerhalb des Linsenkörpers der Magnetlinse (ML) angeordnet ist.

9. Detektoranordnung nach einem der Ansprüche 1 bis 7, dadurch gekennzeichnet, daß der Detektor (DT) unmittelbar oberhalb des Linsenkörpers der Magnetlinse (ML) angeordnet ist.

10. Detektoranordnung nach einem der Ansprüche 1 bis 9, gekennzeichnet durch einen ringförmigen Detektor (DT) mit einer konzentrisch zur Symmetrieachse (OA) der Magnetlinse (ML) angeordneten hohlzylinderförmigen Abschirmung (RE).

11. Detektoranordnung nach Anspruch 10, dadurch gekennzeichnet, daß die Abschirmung (RE) auf einem Potential ($U_{RE}$) liegt, dessen Betrag kleiner oder gleich dem Betrag des Potentials ($U_{KE}$) der ersten Elektrode (KE) der Immersionslinse ist.

12. Detektoranordnung nach einem der Ansprüche 1 bis 11, gekennzeichnet durch eine Szintillator-Lichtleiterkombination als Detektor (DT).

13. Detektoranordnung nach einem der Ansprüche 1 bis 11, gekennzeichnet durch einen Halbleiterdetektor (DT).

14. Detektoranordnung nach einem der Ansprüche 1 bis 11, gekennzeichnet durch einen Oberflächensperrschichtdetektor (DT).

15. Detektoranordnung nach einem der Ansprüche 1 bis 14, dadurch gekennzeichnet, daß der Detektor (DT) einen aus mehreren Segmenten bestehenden teilchensensitiven Bereich (ES) aufweist.

16. Detektoranordnung nach einem der Ansprüche 1 bis 15, gekennzeichnet durch eine symmetrische Magnetlinse (ML).

17. Detektoranordnung nach einem der Ansprüche 1 bis 15, gekennzeichnet durch eine unsymmetrische Magnetlinse (ML).

18. Detektoranordnung nach einem der Ansprüche 1 bis 15, gekennzeichnet durch eine konische Magnetlinse (ML).

19. Detektoranordnung nach einem der Ansprüche 1 bis 18, dadurch gekennzeichnet, daß die erste Elektrode (KE) der Immersionslinse auf einem positiven Potential ($U_{KE}$) liegt und der untere Polschuh (UP) auf Erdpotential ($U_{UP}$) liegt.

20. Detektoranordnung nach einem der Ansprüche 1 bis 17, dadurch gekennzeichnet, daß das Potential ($U_{KE}$) der ersten Elektrode (KE) dem Betrag nach größer als das Potential ($U_{UP}$) der zweiten Elektrode (UP) der Immersionslinse ist.

**Claims**

1. Detector arrangement with a detector objective for corpuscular beam devices, with
    a) a magnetic lens (ML) which produces an almost rotationally symmetric magnetic field,
    b) an electrostatic immersion lens which produces an almost rotationally symmetric electric field, is arranged within the magnetic lens (ML) symmetrically with respect to the axis of symmetry (OA) thereof and has at least two electrodes (KE, UP) lying at different potentials ($U_{KE}$, $U_P$) which produce an electric retarding field which retards the corpuscles of a primary corpuscular beam (PE),
    c) and a detector (DT) which serves to detect the secondary corpuscles (SE) released by the primary corpuscular beam (PE) on a sample (PR) and which – viewed in the direction of the primary corpuscular beam – is arranged symmetrically with respect to the axis of symmetry (OA) before the pole piece gap (PS) of the magnetic lens (ML).

2. Detector arrangement as claimed in claim 1, characterised in that a first electrode (KE) of the immersion lens is arranged in the upper pole piece (OP) of the magnetic lens (ML).

3. Detector arrangement as claimed in claims 1 or 2, characterised in that the lower pole piece (UP) of the magnetic lens (ML) forms a second electrode of the immersion lens.

4. Detector arrangement as claimed in one of claims 1 to 3, characterised in that the magnetic lens (ML) has in the upper pole piece (OP) a bore in the shape of a truncated cone which tapers in the direction of the sample (PR).

5. Detector arrangement as claimed in one of claims 1 to 3, characterised in that the magnetic lens (ML) has a cylindrical bore in the upper pole piere (OP).

6. Detector arrangement as claimed in one of claims 1 to 5, characterised in that the first electrode (KE) of the immersion lens is constructed as a hollow cylinder.

7. Detector arrangement as claimed in one of claims 1o to 5, characterised in that the first electrode (KE) of the immersion lens is constructed as a truncated cone with a hollow cylindrical attachment.

8. Detector arrangement as claimed in one of claims 1 to 7, characterised in that the detector (DT) is arranged within the lens body of the magnetic lens (ML).

9. Detector arrangement as claimed in one of claims 1 to 7, characterised in that the detector (DT) is arranged immediately above the lens body of the magnetic lens (ML).

10. Detector arrangement as claimed in one of claims 1 to 9, characterised by an annular detector (DT) with a hollow cylindrical shield (RE) arranged concentrically with respect to the axis of symmetry (OA) of the magnetic lens (ML).

11. Detector arrangement as claimed in claim 10, characterised in that the shield (RE) lies at a potential ($U_{RE}$) the magnitude of which is smaller than or equal to the magnitude of the potential ($U_{KE}$) of the first electrode (KE) of the immersion lens.

12. Detector arrangement as claimed in one of claims 1 to 11, characterised by a scintillator-photoconductor combination as detector (DT).

13. Detector arrangement as claimed in one of claims 1 to 11, charactrised by a semiconductor detector (DT).

14. Detector arrangement as claimed in one of claims 1 to 11, characterised by a surface barrier layer detector (DT).

15. Detector arrangement as claimed in one of claims 1 to 14, characterised in that the detector (DT) has a particle-sensitive region (ES) consisting of several segments.

16. Detector arrangement as claimed in one of claims 1 to 15, characterised by a symmetric magnetic lens (ML).

17. Detector arrangement as claimed in one of claims 1 to 15, characterised by an unsymmetric magnetic lens (ML).

18. Detector arrangement as claimed in one of claims 1 to 15, characterised by a conical magnetic lens (ML).

19. Detetctor arrangement as claimed in one of claims 1 to 18, characterised in that the first electrode (KE) of the immersion lens lies at a positive potential ($U_{KE}$) and the lower pole piece (UP).

20. Detector arrangement as claimed in one of claime 1 to 17, characterised in that the potential ($U_{KE}$) of the first electrode (KE) is greater as regards magnitude than the potential ($U_{UP}$) of the second electrode (UP) of the second electrode (UP) of the immersion lens.

**Revendications**

1. Appareillage de détectioin comportant un objectif, destiné à des émetteurs de rayonnement corpusculaire et comprenant:

a) une lentille magnétique (ML) générant un champ magnétique pratiquement symétrique de révolution,

b) une lentille électrostatique à immersion générant un champ électrique pratiquement symétrique de révolution, disposée à l'intérieur de la lentille magnétique (ML), symétriquement par rapport à l'axe de symétrie (OA) de cette dernière, et comprenant au moins deux électrodes (KE, UP) qui sont à des potentiels différents ($U_{KE}$, $U_P$) et qui génèrent un champ électrique de décélération qui freine les corpuscules d'un faisceau primaire (PE),

c) ainsi qu'un détecteur (DT) qui est destiné à déceler les corpuscules secondaires (SE) dégagés sur l'échantillon (PR) du faisceau corpusculaire primaire (PE) et qui est disposé – par rapport au sens du faisceau corpusculaire primaire – au devant de l'intervalle (PS) entre pièces polaires de la lentille magnétique (ML), symétriquement par rapport à l'axe de symétrie (OA).

2. Appareillage de détection selon la revendication 1, caractérisé en ce qu'une première électrode (KE) de la lentille à immersion est disposée à l'intérieur de la pièce polaire supérieure (OP) de la lentille magnétique (ML).

3. Appareillage de détection selon l'une ou l'autre des revendications 1 et 2, caractérisé en ce que la pièce polaire inférieure (UP) de la lentille magnétique (ML) forme une seconde électrode de la lentille à immersion.

4. Appareillage de détection selon l'une quelconque des revendications 1 à 3, caractérisé en ce que la lentille magnétique (ML) présente dans la pièce polaire supérieure (OP) une cavité tronconique qui se rétrécit vers l'échantillon (PR).

5. Appareillage de détection selon l'une quelconque des revendications 1 à 3, caractérisé en ce que la lentille magnétique (ML) présente une cavité cylindrique à l'intérieur de la pièce polaire supérieure (OP).

6. Appareillage de détection selon l'une quelconque des revendications 1 à 5, caractérisé en ce que la première électrode (KE) de la lentille à immersion est conformée en cylindre creux.

7. Appareillage de détection selon l'une quelconque des revendications 1 à 5, caractérisé en ce que la première électrode (KE) de la lentille à immersion est conformée en tronc de cône comportant un prolongement en forme de cylindre creux

8. Appareillage de détection selon l'une quelconque des revendications 1 à 7, caractérisé en ce que le détecteur (DT) est disposé à l'intérieur du corps de la lentille magnétique (ML).

9. Appareillage de détection selon l'une quelconque des revendications 1 à 7, caractérisé en ce que le détecteur (DT) est disposé immédiatement au-dessus du corps de la lentille magnétique (ML).

10. Appareillage de détection selon l'une quelconque des revendications 1 à 9, caractérisé par un détecteur annulaire (DT) comportant un écran (RE) en forme de cylindre creux disposé concentriquement à l'axe de symétrie (OA) de la lentille magnétique (ML).

11. Appareillage de détection selon la revendication 10, caractérisé en ce que l'écran (RE) est un potentiel ($U_{RE}$) qui est inférieur ou égal au potentiel ($U_{KE}$) de la première électrode (KE) de la lentille à immersion.

12. Appareillage détecteur selon l'une quelconque des revendications 1 à 11, caractérisé en ce que le détecteur (DT) consiste en une combinaison d'un scintillateur et d'un guide de lumière.

13. Appareillage détecteur selon l'une quelconque des revendications 1 à 11, caractérisé par un détecteur à semi-conducteurs (DT).

14. Appareillage détecteur selon l'une quelconque des revendications 1 à 11, caractérisé par un détecteur (DT) à couche d'arrêt superficielle.

15. Appareillage détecteur selon l'une quelconque des revendications 1 à 14, caractérisé en ce que le détecteur (DT) comporte une zone (ES) qui est sensilbe aux particules et qui se compose de plusieurs segments.

16. Appareillage détecteur selon l'une quelconque des revendications 1 à 15, caractérisé par une lentille magnétique (ML) qui est symétrique.

17. Appareillage détecteur selon l'une quelconque des revendications 1 à 15, caractérisé par une lentille magnétique (ML) qui est asymétrique.

18. Appareillage détecteur selon l'une quelconque des revendications 1 à 15, caractérisé par une lentille magnétique (ML) qui est conique.

19. Appareillage détecteur selon l'une quelconque des revendications 1 à 18, caractérisé en ce que la première électrode (KE) de la lentille à immersion est à un potentiel positif ($U_{KE}$) et la pièce polaire inférieure (UP) est au potentiel de la masse ($U_{UP}$).

20. Appareillage détecteur selon l'une quelconque des revendications 1 à 17, caractérisé en ce que le potentiel ($U_{KE}$) de la première électrode (KE) est supérieur au potentiel ($U_{UP}$) de la seconde électrode (UP) de la lentille à immersion.

FIG 1

FIG 2